# EUROPÄISCHE PATENTANMELDUNG

(11) **EP 0 854 501 A2**
(43) Veröffentlichungstag der Anmeldung: **22.07.1998**
(21) Anmeldenummer: 97122579.2
(22) Anmeldetag: 19.12.1997
(51) Int. Cl.: H01L 21/3063, C25F 3/14

(54) **Verfahren zur Bildung von Lochstrukturen in einem Siliziumsubstrat durch elektrochemisches Ätzen**

(30) Priorität: 14.01.1997 DE 19700982
(71) Anmelder: SIEMENS AKTIENGESELLSCHAFT, 80333 München (DE)
(72) Erfinder: Grüning, Ulrike, Dr., Wappingers Falls, NY 12590 (US); Wendt, Hermann, Dr., 85630 Grasbrunn (DE); Lehmann, Volker, Dr., 80689 München (DE)

(57) **Zusammenfassung**

Zur Bildung von Lochstrukturen in einem seitlich begrenzten Bereich (14) eines Siliziumsubstrates (11) durch elektrochemisches Ätzen wird die elektrochemische Ätzung außerhalb dieses Bereiches (14) durch elektrisches Abführen von Ladungsträgern über eine Diodenstruktur elektrisch unterdrückt.

## Beschreibung

Durch elektrochemisches Ätzen in einem flußsäurehaltigen Elektrolyten lassen sich in n-dotiertem Silizium porenartige Lochstrukturen herstellen. Eine Untersuchung über das elektrochemische Ätzen von n-dotiertem Silizium ist in V. Lehmann, J. Electrochem. Soc. 140 (1993), Seite 2836 ff., veröffentlicht.

Die Lochstrukturen sind dabei mehr oder weniger regelmäßig angeordnet und können Aspektverhältnisse bis zu 500 aufweisen.

Derartige Lochstrukturen werden insbesondere zur Bildung von tiefen, dotierten Gebieten, zur Oberflächenvergrößerung oder zur Herstellung von Kondensatoren eingesetzt.

Für verschiedene Anwendungen, zum Beispiel für DRAM-Anordnungen oder für integrierte Schaltungen mit Logikbauelementen oder mit Leistungsbauelementen ist es wünschenswert, derartige Lochstrukturen lokal begrenzt auf einer Siliziumscheibe zu erzeugen. Das heißt, die Oberfläche der Siliziumscheibe weist Bereiche auf, in denen keine Lochstrukturen gebildet werden.

Zur Herstellung derart lokal begrenzter Lochstrukturen ist bekannt, den Teil der Siliziumscheibe, in dem keine Lochstrukturen entstehen sollen, mit einer Maske, zum Beispiel aus Photolack, abzudecken. Auf diese Weise hergestellte Lochstrukturen weisen einen unscharfen Rand im Bereich der Maskenkante auf. Insbesondere kommt es zu starken, unkontrollierten Unterätzungen.

Der Erfindung liegt das Problem zugrunde, ein Verfahren zur Bildung von Lochstrukturen in einem Siliziumsubstrat anzugeben, bei dem die Lochstrukturen in einem seitlich begrenzten Teilgebiet des Siliziumsubstrats mit einem schärferen Übergang zwischen geätztem und nicht geätztem Gebiet herstellbar sind.

Dieses Problem wird erfindungsgemäß gelöst durch ein Verfahren nach Anspruch 1. Weitere Ausgestaltungen der Erfindung gehen aus den Unteransprüchen hervor.

In dem Verfahren wird an einer Hauptfläche des n-dotierten Siliziumsubstrats ein zu strukturierender Bereich definiert, in dem nachfolgend die Lochstrukturen gebildet werden. Mindestens der zu strukturierende Bereich der Hauptfläche wird mit einem fluoridhaltigen Elektrolyten in Kontakt gebracht. Das Siliziumsubstrat wird dabei gegenüber dem Elektrolyten als Anode verschaltet. Die Lochstrukturen in dem zu strukturierenden Bereich werden durch elektrochemisches Ätzen gebildet. Außerhalb des zu strukturierenden Bereiches wird die elektrochemische Ätzung durch elektrisches Abführen von Ladungsträgern über eine Diodenstruktur elektrisch unterdrückt.

Die Erfindung macht sich die Erkenntnis zunutze, daß bei einer elektrochemischen Ätzung, bei der das Substrat als Anode verschaltet ist, sich Minoritätsladungsträger in dem n-dotierten Silizium zu der mit dem Elektrolyten in Kontakt stehenden Hauptfläche bewegen. An dieser Hauptfläche bildet sich eine Raumladungszone aus. Da die Feldstärke im Bereich von Vertiefungen, die mit statistischer Verteilung in jeder Oberfläche vorhanden sind, in der Hauptfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsladungsträger bewegen sich wegen der vergrößerten elektrischen Feldstärke dorthin und desto stärker ist der Ätzangriff an dieser Stelle. Für den Ätzangriff ist ein Ladungsträgerstrom erforderlich.

In dem erfindungsgemäßen Verfahren wird dafür Sorge getragen, daß der Ladungsträgerstrom außerhalb des zu strukturierenden Bereiches die Hauptfläche des Siliziumsubstrats nicht erreicht. Dieses erfolgt dadurch, daß der Ladungsträgerstrom elektrisch abgeführt wird.

Zum elektrischen Anführen der Ladungsträger wird außerhalb des zu strukturierenden Bereiches eine Diodenstruktur gebildet, über die bei der elektrochemischen Ätzung Ladungsträger abfließen. Eine solche Diodenstruktur kann durch einen lokalen pn-Übergang realisiert werden. Dazu wird ein p-dotiertes Gebiet erzeugt, das den zu strukturierenden Bereich der Hauptfläche seitlich begrenzt und dadurch definiert. Das p-dotierte Gebiet kann durch Diffusion, Implantation oder durch Aufbringen und Strukturieren einer p-dotierten Polysiliziumschicht oder einer p-dotierten epitaktischen Schicht gebildet werden. Das p-dotierte Gebiet wird gegenüber dem Elektrolyten als Kathode verschaltet. Bei einer derartigen Polung wird das p-dotierte Gebiet in Sperrichtung gegenüber dem Elektrolyten betrieben. Dabei tritt keine Siliziumauflösung auf. Eine Ätzung in diesem Bereich wird damit verhindert.

Es liegt im Rahmen der Erfindung, die Diodenstruktur als fluoridbeständigen Metall-Halbleiter-Schottky-Kontakt auszubilden. Dazu wird außerhalb des zu strukturierenden Bereichs an der Hauptfläche ein Metallkontakt gebildet, der mit dem Siliziumsubstrat eine Schottky-Diode bildet. Der Metallkontakt begrenzt den zu strukturierenden Bereich seitlich.

Es liegt ferner im Rahmen der Erfindung, eine dielektrische Struktur vorzusehen, die die Hauptfläche der Diodenstruktur teilweise bedeckt. Lediglich im Grenzbereich zwischen dem zu strukturierenden Bereich und dem Bereich, der nicht geätzt werden soll, ist das Vorhandensein des pn-Überganges bzw. Metall-Halbleiter-Schottky-Übergang erforderlich. Ist die Hauptfläche außerhalb des zu strukturierenden Bereichs teilweise von der dielektrischen Struktur bedeckt, so wirkt diese als Maske. Das Problem der unscharfen Begrenzung des zu strukturierenden Bereichs wird dadurch gelöst, daß im Grenzbereich die Diodenstruktur vorhanden ist, die den zu strukturierenden Bereich seitlich begrenzt und dadurch definiert.

Es liegt ferner im Rahmen der Erfindung, den Ladungsträgerstrom außerhalb des zu strukturierenden Bereichs über eine MIS-Struktur abzuleiten. Dazu wird auf der Hauptfläche ein Gatedielektrikum und eine Gateelektrode gebildet, die den zu strukturierenden Bereich seitlich begrenzen und dadurch definieren. Auf der dem zu strukturierenden Bereich abgewandten Seite der Gateelektrode wird ein p-dotiertes Gebiet gebildet. Die Gateelektrode wird so angesteuert, daß sich unterhalb der Gateelektrode ein leitender Kanal ausbildet, in dem der Ladungsträgerstrom zu dem p-dotierten Gebiet abgeleitet wird und über dieses abfließt. Dabei liegt es im Rahmen der Erfindung, die Gateelektrode und das p-dotierte Gebiet auf gleiches Potential zu legen. Dadurch wird der Schaltungsaufwand reduziert.

Im folgenden wird die Erfindung anhand von Ausführungsbeispielen, die in den Figuren dargestellt sind, näher erläutert.

Die Darstellungen in den Figuren sind nicht maßstäblich.
- Figur 1: zeigt die Herstellung von Lochstrukturen, wobei außerhalb des zu strukturierenden Bereiches eine Diodenstruktur mit einem pn-Übergang vorgesehen ist zur Unterdrückung der elektrochemischen Ätzung in diesem Bereich.
- Figur 2: zeigt die Herstellung von Lochstrukturen in einem Siliziumsubstrat, wobei zur Unterdrückung der elektrochemischen Ätzung außerhalb des zu strukturierenden Bereichs eine Schottky-Diode vorgesehen ist.
- Figur 3: zeigt die Bildung von Lochstrukturen in einem Siliziumsubstrat, wobei zur Unterdrückung der elektrochemischen Ätzung außerhalb des zu strukturierenden Bereichs eine MIS-Struktur vorgesehen ist.

Ein n-dotiertes Siliziumsubstrat 11 mit einer Dotierstoffkonzentration im Bereich von 10¹⁶ cm⁻³ weist ein p-dotiertes Gebiet 12 auf, in dem eine Dotierstoffkonzentration im Bereich von 10¹⁹ cm⁻³ eingestellt ist. Das p-dotierte Gebiet 12 grenzt an eine Hauptfläche 13 des Siliziumsubstrats 11 an. Es begrenzt einen zu strukturierenden Bereich 14 seitlich. Das p-dotierte Gebiet 12 weist eine Tiefe von zum Beispiel 1 µm auf. Die Hauptfläche 13 wird mit einem fluoridhaltigen Elektrolyten 15, der zum Beispiel in einem dicht an die Hauptfläche 13 angrenzenden Gefäß 151 vorhanden ist, in Kontakt gebracht. Der Elektrolyt 15 weist eine Fluoridkonzentration von 1 bis 50 Gewichtsprozent, vorzugsweise 3 Gewichtsprozent, auf. Zwischen das Siliziumsubstrat 11 und den Elektrolyten 15 wird eine Spannung so angelegt, daß das n-dotierte Siliziumsubstrat 11 und damit der zu strukturierende Bereich 14 als Anode verschaltet ist. Zwischen das p-dotierte Gebiet 12 und den Elektrolyten 15 wird eine Spannung so angelegt, daß das p-dotierte Gebiet 12 als Kathode verschaltet ist. Zum Beispiel wird der Elektrolyt 15 gegenüber dem Siliziumsubstrat 11 auf ein Potential von - 3 Volt gelegt. Das p-dotierte Gebiet 12 wird zum Beispiel auf ein Potential von - 3,5 Volt gegenüber dem Siliziumsubstrat 11 gelegt. Dadurch liegt das p-dotierte Gebiet 12 auf einem um 0,5 Volt negativeren Potential als der Elektrolyt 15. Das Siliziumsubstrat 11 wird von einer Rückseite 16, die der Hauptfläche 13 gegenüberliegt, beleuchtet, um die Stromdichte bei der elektrochemischen Ätzung im Siliziumsubstrat 11 einzustellen. Durch die Beschaltung des Siliziumsubstrats 11, des Elektrolyten 15 und des p-dotierten Gebietes 12 fließen Ladungsträger in dem zu strukturierenden Bereich 14 zur Hauptfläche 13. Dort kommt es zur Auflösung des Siliziums und dadurch zur Bildung von Lochstrukturen 17.

Bei der Ätzung ist der aus p-dotiertem Gebiet 12 und n-dotiertem Siliziumsubstrat 11 gebildete pn-Übergang in Sperrichtung gepolt. Dadurch fließt wegen der Beleuchtung von der Rückseite 16 her ein beleuchtungsabhängiger Photostrom über die aus p-dotiertem Gebiet 12 und n-dotiertem Siliziumsubstrat 11 gebildete pn-Diode. Da das p-dotierte Gebiet 12 jedoch als Kathode gegenüber dem Elektrolyten 15 gepolt ist, findet in diesem Bereich keine Siliziumauflösung statt. Das p-dotierte Gebiet 12 ist gegenüber dem Elektrolyten in Sperrichtung gepolt. Dadurch tritt lediglich ein geringer Dunkelstrom auf, der allenfalls zu einer Wasserstoffentwicklung führt.

Die Lochstrukturen 17 entstehen nur in dem zu strukturierenden Bereich 14. Im Bereich der Hauptfläche 13 weist der zu strukturierende Bereich 14 eine scharfe Begrenzung auf. Erst wenn die Lochstrukturen 17 eine Tiefe erreichen, die der Tiefe des p-dotierten Gebietes 12 entspricht, kann es zu einem seitlichen Wachstum der Lochstrukturen 17 kommen. Es ist daher vorteilhaft, die Tiefe des p-dotierten Gebietes 12 so zu wählen, daß sie der Tiefe der herzustellenden Lochstrukturen 17 entspricht.

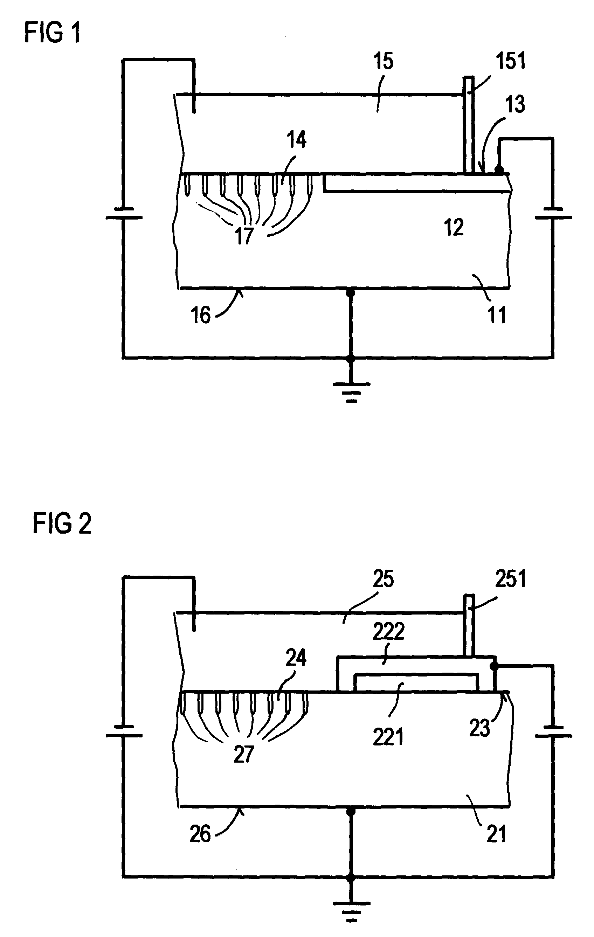

Gemäß einer zweiten Ausführungsform der Erfindung ist ein Siliziumsubstrat 21, das n-dotiert mit einer Dotierstoffkonzentration von 10¹⁶ cm⁻³ ist, mit einer dielektrischen Struktur 121 und einem diese überdeckenden Metallkontakt 122 versehen (siehe Figur 2). Die dielektrische Struktur 221 wird zum Beispiel aus SiO₂ oder Si₃N₄ gebildet und weist eine Dicke von zum Beispiel 100 nm auf. Die dielektrische Struktur 221 wird vollständig von dem Metallkontakt 222 überdeckt. Der Metallkontakt 222 reicht seitlich über die dielektrische Struktur 221 hinaus. Der Metallkontakt 222 begrenzt an einer Hauptfläche 23 einen zu strukturierenden Bereich 24 seitlich. Der Metallkontakt 222 wird aus einem Metall gebildet, das einen Metall-Halbleiter-Schottky-Kontakt bildet. Der Metallkontakt 222 wird vorzugsweise aus Platin gebildet.

Zur elektrochemischen Ätzung wird mindestens in dem zu strukturierenden Bereich 24 die Hauptfläche 23 mit einem fluoridhaltigen sauren Elektrolyten 25 in Kontakt gebracht. Der Elektrolyt 25 weist eine Fluoridkonzentration von 1 bis 50 Gewichtsprozent, vorzugsweise 3 Gewichtsprozent, auf. Der Elektrolyt 25 ist zum Beispiel in einem dicht an die Hauptfläche 23 oder den Metallkontakt 222 anschließendes Gefäß 251 enthalten.

Das Siliziumsubstrat 21 wird gegenüber dem Elektrolyten 25 als Anode verschaltet. Der Elektrolyt 25 wird zum Beispiel auf - 3 Volt gegenüber dem Substrat und der Metallkontakt 222 auf - 3,0 Volt gegenüber dem Substrat gelegt. Die durch den Metallkontakt 222 und das Siliziumsubstrat 21 gebildete Schottky-Diode ist dadurch in Sperrichtung gepolt.

Bei der elektrochemischen Ätzung wird das Siliziumsubstrat 21 von einer Rückseite 26, die der Hauptfläche 23 gegenüberliegt, her beleuchtet. Über die Schottky-Diode fließt dabei ein beleuchtungsabhängiger Photostrom. Da der Metallkontakt 222 als Kathode verschaltet ist, kommt es im Bereich der Schottky-Diode nicht zur Siliziumauflösung. In dem zu strukturierenden Bereich 24 dagegen bildet sich ein Ladungsträgerstrom, der bis zur Hauptfläche 23 fließt und die Bildung von Lochstrukturen 27 durch elektrochemische Ätzung bewirkt. Der zu strukturierende Bereich 24 mit den Lochstrukturen 27 wird mit scharfer seitlicher Begrenzung gebildet, wobei die Tiefe, bis in die eine scharfe Begrenzung auftritt, von der Ausdehnung der Raumladungszone und damit dem an den Metallkontakt 222 angelegten Potential abhängt.

Unterhalb des Metallkontaktes 222 in der dielektrischen Struktur 221 wird der Ladungsträgerstrom über die Metall-Halbleiter-Schottky-Kontakte an der Hauptfläche 23 abgeführt. Der Metallkontakt 222 ragt in dem beschriebenen Ausführungsbeispiel beidseitig über die dielektrische Struktur 221 hinaus, so daß im Schnitt in Figur 2 auf beiden Seiten der dielektrischen Struktur 221 Metall-Halbleiter-Schottky-Kontakte entstehen. Dadurch wird der Ladungsträgerabfluß über den Metallkontakt 222 verstärkt. Die Erfindung ist auch durchführbar, wenn nur ein Metall-Halbleiter-Kontakt gebildet wird, der den zu strukturierenden Bereich 24 seitlich begrenzt.

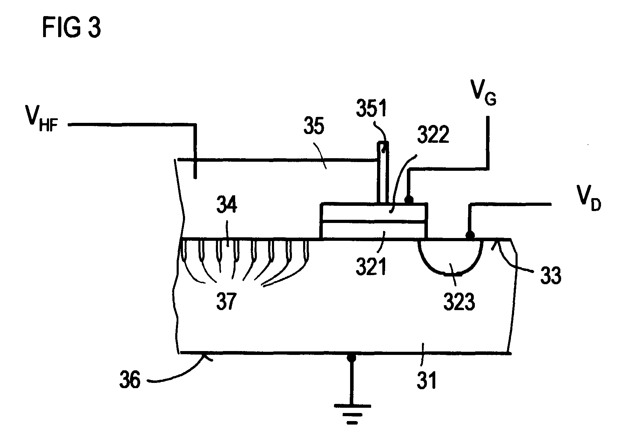

In einem dritten Ausführungsbeispiel weist ein Siliziumsubstrat 31 ein Gatedielektrikum 321 und eine Gateelektrode 322 auf, die an einer Hauptfläche 33 des Siliziumsubstrats 31 angeordnet sind (siehe Figur 3). Das Siliziumsubstrat 33 ist n-dotiert mit einer Dotierstoffkonzentration von zum Beispiel 10¹⁶ cm⁻³. In dem Siliziumsubstrat 31 ist an die Hauptfläche 33 angrenzend ein p-dotiertes Gebiet 323, das eine Dotierstoffkonzentration von 10¹⁹ cm⁻³ aufweist, vorgesehen.

Die Gateelektrode 322 und das Gatedielektrikum 321 begrenzen einen zu strukturierenden Bereich 34 in der Hauptfläche 33 seitlich. Das Gatedielektrikum 321 wird zum Beispiel aus Siliziumoxid oder Siliziumnitrid gebildet. Die Gateelektrode 322 wird zum Beispiel aus Polysilizium gebildet.

Die Hauptfläche 33 wird in dem zu strukturierenden Bereich 34 mit einem fluoridhaltigen Elektrolyten 35 in Kontakt gebracht. Der fluoridhaltige Elektrolyt 35 weist eine Fluoridkonzentration von 1 bis 50 Gewichtsprozent, vorzugsweise 3 Gewichtsprozent, auf. Der Elektrolyt 35 ist zum Beispiel in einem dicht an die Hauptfläche 32 oder die Gateelektrode 322 anschließendes Gefäß enthalten.

Bei der elektrochemischen Ätzung wird eine Rückseite 36, die der Hauptfläche 33 gegenüberliegt, beleuchtet. Das Siliziumsubstrat 31 wird gegenüber dem Elektrolyten 35 als Anode verschaltet. Dazu wird der Elektrolyt 35 gegenüber dem Siliziumsubstrat 31 auf ein Potential von zum Beispiel V_{HF} = - 3 V gelegt. Die Gateelektrode 322 wird dabei auf ein Potential von V_{G} = - 4,0 V, das p-dotierte Gebiet 323 auf ein Potential von V_{D} = - 3,5 V gelegt.

Bei der elektrochemischen Ätzung kommt zu einem Ladungsträgerstrom von der beleuchteten Rückseite 36 zur Hauptfläche 33 im zu strukturierenden Bereich 34. Dadurch bilden sich im zu strukturierenden Bereich 34 Lochstrukturen 37. Außerhalb des zu strukturierenden Bereichs 34 kommt es unterhalb der Gateelektrode 322 zur Ausbildung eines p-leitenden Kanals, über den der Ladungsträgerstrom zu dem p-dotierten Gebiet 323 abgeleitet wird. Dadurch wird ein Ätzangriff unterhalb der Gateelektrode 322 vermieden. Die Lochstrukturen 37 weisen bis in eine Tiefe, die der Tiefe des p-dotierten Gebietes 323 entspricht, eine scharfe seitliche Begrenzung auf, die durch den p-leitenden Kanal unterhalb der Gateelektrode 322 bewirkt wird.

Vorzugsweise werden die Gateelektrode 322 und das p-dotierte Gebiet 323 auf gleiches Potential gelegt, da dann der Schaltungsaufwand reduziert wird. Dazu kann die Gateelektrode 322 das Gatedielektrikum 321 auf der dem zu strukturierenden Bereich 34 abgewandten Seite seitlich überragen, so daß das p-dotierte Gebiet 323 direkt mit der Gateelektrode 322 verbunden ist (nicht dargestellt).

### Bezugszeichenliste

- 11: Siliziumsubstrat
- 12: p-dotiertes Gebiet
- 13: Hauptfläche
- 14: zu strukturierender Bereich
- 15: Elektrolyt
- 151: Gefäß
- 16: Rückseite
- 17: Lochstrukturen
- 21: Siliziumsubstrat
- 221: dielektrische Struktur
- 222: Metallkontakt
- 23: Hauptfläche
- 24: zu strukturierender Bereich
- 25: Elektrolyt
- 251: Gefäß
- 26: Rückseite
- 27: Lochstrukturen
- 31: Siliziumsubstrat
- 321: Gatedielektrikum
- 322: Gateelektrode
- 323: p-dotiertes Gebiet
- 33: Hauptfläche
- 34: zu strukturierender Bereich
- 35: Elektrolyt
- 351: Gefäß
- 36: Rückseite
- 37: Lochstrukturen

## Patentansprüche

1. Verfahren zur Bildung von Lochstrukturen in einem Siliziumsubstrat,
- bei dem an einer Hauptfläche (13) eines n-dotierten Siliziumsubstrats (11) ein zu strukturierender Bereich (14) definiert wird, in dem nachfolgend die Lochstrukturen (17) gebildet werden,
- bei dem mindestens der zu strukturierende Bereich (14) der Hauptfläche (13) mit einem fluoridhaltigen Elektrolyten (15) in Kontakt gebracht wird,
- bei dem das Siliziumsubstrat (11) gegenüber dem Elektrolyten (15) als Anode verschaltet wird,
- bei dem die Lochstrukturen (17) in dem zu strukturierenden Bereich (14) durch elektrochemisches Ätzen gebildet werden,
- bei dem außerhalb des zu strukturierenden Bereichs (14) eine Diodenstruktur (11, 12) gebildet wird, über die bei der elektrochemischen Ätzung die Ladungsträger abfließen, so daß die elektrochemische Ätzung außerhalb des zu strukturierenden Bereichs (14)unterdrückt wird.

2. Verfahren nach Anspruch 1,
bei dem außerhalb des zu strukturierenden Bereichs (14) an der Hauptfläche (13) ein p-dotiertes Gebiet (12) gebildet wird, das beim elektrochemischen Ätzen gegenüber dem Elektrolyten (15) als Kathode verschaltet wird.

3. Verfahren nach Anspruch 2,
bei dem die Oberfläche des p-dotierten Gebietes (12) teilweise mit einer dielektrischen Struktur bedeckt wird.

4. Verfahren nach Anspruch 1,
bei dem außerhalb des zu strukturierenden Bereichs (24) an der Hauptfläche (23) ein Metallkontakt (222) gebildet wird, der mit dem Siliziumsubstrat (21) eine Schottky-Diode bildet.

5. Verfahren nach Anspruch 4,
bei dem zwischen dem Metallkontakt (222) und der Hauptfläche (23) eine dielektrische Struktur (221) angeordnet wird, die der Metallkontakt (222) seitlich überragt.

6. Verfahren nach Anspruch 1,
bei dem außerhalb des zu strukturierenden Bereichs (34) eine MIS-Struktur (321, 322, 323) gebildet wird, die ein Gatedielektrikum (321) und eine Gateelektrode (322) aufweist, die dem zu strukturierenden Bereich (34) benachbart gebildet werden, und die auf der dem zu strukturierenden Bereich (34) abgewandten Seite der Gateelektrode (322) ein p-dotiertes Gebiet (323) aufweist.

7. Verfahren nach einem der Ansprüche 1 bis 6,
bei dem bei der elektrochemischen Ätzung das Siliziumsubstrat (11) von einer der Hauptfläche (13) gegenüberliegenden Rückseite (16) her beleuchtet wird.
